Europäisches Patentamt

European Patent Office

Office européen des brevets

(19)

(11) **EP 0 492 549 B1**

(12)

# EUROPEAN PATENT SPECIFICATION

(45) Date of publication and mention
of the grant of the patent:
**15.07.1998 Bulletin 1998/29**

(51) Int Cl.⁶: **H04J 3/07**

(21) Application number: **91122023.4**

(22) Date of filing: **20.12.1991**

(54) **Method for the reduction of phase noise introduced by the SDH network (synchronous digital hierarchy network) by pointer justification and integrated circuits for the implementation of the method**

Verfahren zur Reduzierung von Phasenrauschen verursacht in einem SDH-Netzwerk mittels Zeichenstopftechnik, und integrierte Schaltungen geeignet zur Implementierung dieses Verfahrens

Méthode pour réduire le bruit de phase introduit dans un réseau de type SDH utilisant une justification par pointeurs, et circuits integrés propres à une mise en oeuvre de cette méthode

(84) Designated Contracting States:
**BE CH DE ES FR GB LI NL SE**

(30) Priority: **21.12.1990 IT 2249590**

(43) Date of publication of application:
**01.07.1992 Bulletin 1992/27**

(73) Proprietor: **ALCATEL ALSTHOM COMPAGNIE GENERALE D'ELECTRICITE**
**75008 Paris (FR)**

(72) Inventors:
• **Frigerio, Silvano**
**I-22063 Cantù (CO) (IT)**
• **Gastaldello, Stefano**
**I-35037 Teolo (PD) (IT)**
• **Russo, Giovanni**
**I-96016 Lentini (SR) (IT)**

(74) Representative: **Strehl Schübel-Hopf & Partner**
**Maximilianstrasse 54**
**80538 München (DE)**

(56) References cited:
• **BRITISH TELECOM CONTRIBUTION TO T1 STANDARDS PROJECT. T1X1. 6/89 012 ; 8. FEB. 1989 ; A. REID : ' SONET DESYNCHRONISERS '**
• **ELECTRONICS LETTERS. vol. 26, no. 16, 2 August 1990, STEVENAGE GB pages 1227 -**
• **1228 R. NAWROCKI ET AL. 'WAITING TIME JITTER REDUCTION BY FILL LOCKING'**

**Description**

The present invention provides a method for reducing in reception the phase noise introduced through pointer justification by the SDH network (Synchronous Digital Hierarchy Network) in the transmitted digital signal, in which method: a) occasional redundancies associated to the bit justification and b) the fixed redundancies with c) the occasional prefiltered redundancies associated to the pointer justification, are combined, and the combined signal is filtered in APLL (Analog Phase Locked Loop). The invention also refers to the devices for the implementation of said method.

State of the Art

In Electronics Letters, R. Nawrocki, W. Ehrlich, Vol. 26, No. 16, 2 August 1990, Stevenage, Herts., GB, pages 1227 - 1228, a new method is disclosed for reducing the waiting time jitter (WTJ) in synchronous transmission standards, such as SDH (synchronous digital hierarchy). The WTJ is caused by the so-called positive-zero-negative stuffing. If the fill of the elastic store of the destuffing device precisely follows the fill of the stuffing device, the WTJ is made smaller. The present invention is also related to SDH networks. A method is provided for reducing in reception the phase noise introduced through pointer justification in the transmitted digital signal.

It is known that the resynchronization of VC (Virtual Container) in a node of SDH network is obtained by the pointer justification mechanism. This mechanism is described in wide details and according to the VC type in recommendations G.708 and G.709 draft by CCITT. For a good comprehension of the following it is sufficient to note that each pointer justification corresponds to a sharp phase variation of VC, having a sign equal to the sign of justification and with a value depending on the type of considered VC (in any case not under 8 [UI]), with respect to the synchronous transport frame.

Further it is known that when all of nodes along the path between the source and receiver are synchronized, the pointer justification mechanism works only for adjusting the slow variations of the phase differences among the clocks of the same nodes. This causes the receiver node, and along a sufficiently long observation time, to have an equal number of positive and negative pointer justifications. In better detail the statistics of pointer justifications obtained by several Authors, simulating the behaviour of the network in the hypothesis that all of nodes are synchronized, show that the majority of pointer justifications are considered as "single" justifications by the receiver. Further they show as the sequence formed by a double pointer justification followed by another double pointer justification of the opposite polarity, in case the periods between adjustments of opposite polarity are greather than the receiver time constant, represents, among the sequences which can happen with a probability different from zero, the more critical sequence in terms of phase noise introduced into the network in the case that all of nodes are synchronized.

Further it is known that the statistics of the pointer justifications at the reception node is higly different from the preceding case, if the source and/or receiver node, having lost the network synchronism, are clocked by free references. In this case it is generally present a frequency difference between the clock that has created said VC and the clock that ends it. The frequency difference is at its maximum value when both of nodes are not synchronized with the network and clocked in a manner suitable for showing the maximum allowed frequency difference with opposite sign among one another. This causes all of justifications to have the same sign and to be equispaced by a quantity inversely proportional to the frequency difference present between the two above mentioned clocks on the receiver node.

Further it is known that the sharp phase variations associated to pointer justifications, if they are filtered with a "traditional" APLL (Analog Phase Locked Loop) supply an increase of the phase noise higher than the limits established by the international standards (CCITT, e.g. standard G.783 for the synchronous multiplexers). In fact for satisfying the above mentioned standards it is necessary to use an APLL with very narrow bandwidth (100 mHz - 1 Hz), that cannot be implemented owing to hardware limits.

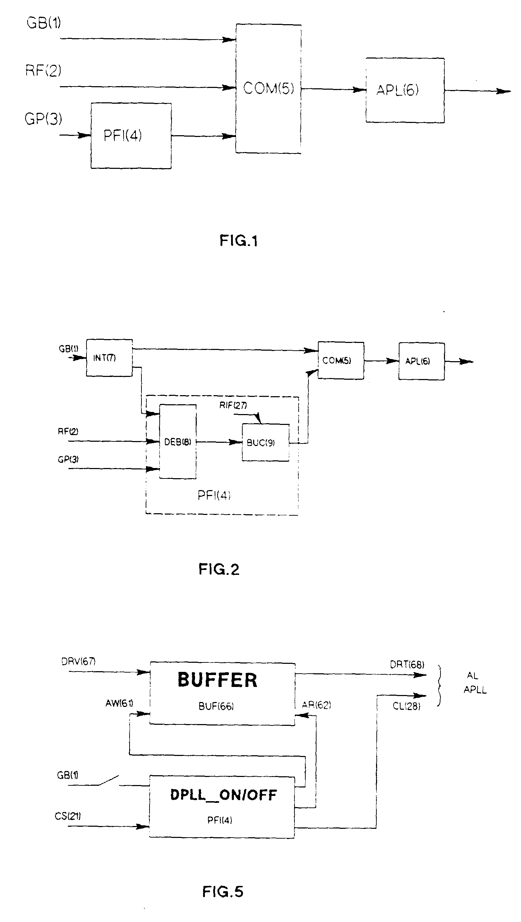

In the literature some methods have been proposed for reducing the phase noise introduced by the SDH network using the pointer justifications. They are based on the idea of prefiltering the phase variations caused by the pointer justifications before reconstructing the continuous data flow by the "traditional" APLL, as shown in Figure 1 (in which GB(1) indicates the occasional redundancies associated to the bit justifications, RF(2) the fixed redundancies, GP(3) the occasional redundancies associated to the pointer justifications, PFI(4) the prefilter, COM(5) the phase detector and APL(6) the APLL by which the continuous data flow is reconstructed).

Said methods differ in the prefiltering type PFI(4) made on the above mentioned phase variations GP(3), associated to the pointer justifications.

A first method proposed in former literature, known under the name of "fixed bit leaking", uses a prefilter PFI (4) that uniformly spreads each phase jump associated to a pointer justification during a fixed time $T_{BL}$. As above said, the loss of synchronism of the source and/or receiver node/s causes the receiver to produce all of justifications having the same sign and equispaced with one another. As using this method the phase jump associated to a justification is not prefiltered until the jump caused by the preceding justification is completely recovered, it can be argued that, if information data must not be lost, it is necessary to limit superiorly the period $T_{BL}$ and therefore also the prefiltering value that can be obtained. This limit appears excessive for the greatest part of multiplexing paths foreseen by the synchronous hierarchy. Therefore this method, although advantageous owing to its implementation simplicity, cannot be considered a general method for the reduction of phase noise joined to the pointer justifications.

The above mentioned drawback is overcome using more complex methods that use adaptive algorithms for the prefiltering.

A good improvement in this direction is the sagacity shown during the meeting of work group ETSI TM3 held in Munich in the period 15-19/10/90. The proposed method includes the use of a DPLL of the second order, with a sufficiently narrow bandwidth and with the output quantized in steps of 1 [UI] for prefiltering the phase variations associated to the pointer justifications GP(3).

For reducing the effects of sharp phase variations (amplitude 1 [UI]), caused by the output quantization, it was introduced an adder node used for adding a RAM stored "dither" inside the loop forming the DPLL.

Although this method is valid on the whole, it shows the following drawbacks:

1) cost for the presence of the RAM that supplies the "dither" signal in digital form;
2) presence of a phase noise of high frequency caused by the "dither" signal and not completely negligible;
3) it is not clear the modality by which the "dither" signal is choosen according to other system parameters.

Summary of the invention

An aim of the present invention is to supply a method and a related implementation device that prevents, among the other things, the above mentioned drawbacks. The method according to the invention foresees, as shown in Figure 2, to prefilter at least the fixed and the occasional redundancies associated to the pointer justifications for supplying a signal easy to be filtered. In better detail, said method includes the following:

1) to establish the ideal response law of prefilter; e. g. the law corresponding to a PLL of the second order;
2) to detect the presence of occasional redundancies and to establish if it is necessary to prefilter also the redundancies associated to the bit justifications:
3) to decide and perform an edge suppression on the reference clock so that, with a phase difference as minimum as possible, the prefilter output coincides with the ideal output established at (1);
4) to accomodate the bit justifications, in the case in which these are not prefiltered, in the holed clock obtained at point (3); this can be done, e.g., suppressing a clock pulse in conjuction with a positive bit justification and eliminating a clock pulse suppression in case of a negative bit justification;

5) to filter, by the "traditional" PLL, the data flow received and re-clocked by the clock obtained in (4) for reconstructing a continuous data flow.

Further characteristics of the method and also other related devices are specified in the following claims.

The different features and advantages of the invention shall appear better by the description of preferred (and not limiting) embodiments thereof, shown in the annexed drawings.

The Figure 2 shows the block scheme of the device according to the invention, including now the two-stage prefilter PFI(4):
x) the block DEB(8) that establishes where the holes must be inserted and y) the block BUC(9) that, after having received the control from block DEB(8), inserts the holes on the reference clock RIF(27). As it is shown, now there are prefiltered not only the occasional redundancies GP(3) associated to the pointer justifications, but also the fixed redundancies RF(2).

According to a feature of the invention, it can be established, operating the switch INT(7), if the occasional redundancies associated to the bit justifications GB(1) must be sent to PFI(4) or if they must applied directly to the phase detector COM(5) and then to the APLL APL (6).

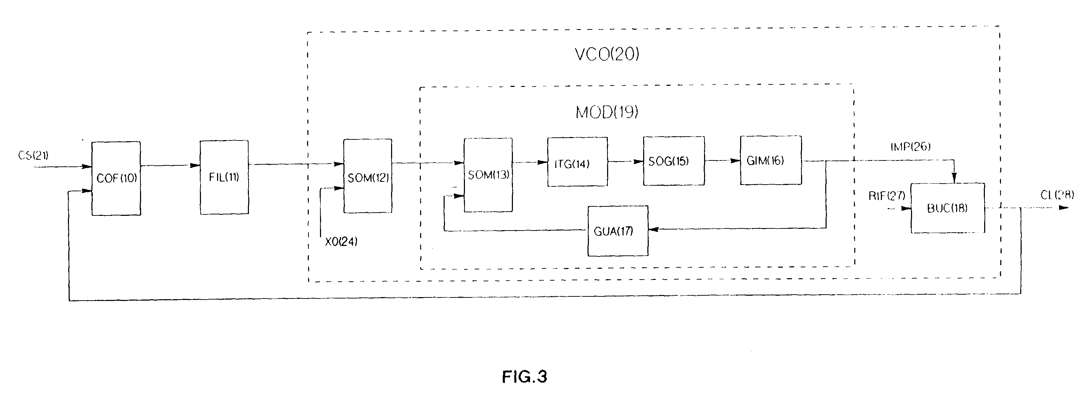

The selection preferred at point(1) foresees the use of a second order negative feedback system named DPLL ON/OFF by us and whose block scheme is referred to in Figure 3. The DPLL_ON/OFF is formed by the following blocks:

1) linear phase detector COF(10)
2) loop filter of the first order FIL(11)
3) VCO_ON/OFF VCO(20)

and according to an advantageous feature of the invention it differs from a usual DPLL in the working features of used VCO.

This last VCO is substantially formed by a modulator SD (Sigma Delta) MOD(19), that generates at output the pulses IMP(26) in conjuction with the holes to be inserted on the reference clock RIF(27).

The modulator SD is also a negative feedback system that, as shown in Figure 3, is formed substantially by an integrator ITG(14), a comparator with a threshold value SOG(15) and a pulse generator GIM(16). Each time the integrated signal exceeds the threshold value, we have the generation of a pulse that, being fed back at input with a proper gain, brings again the integrated signal under threshold.

The holed clock CL(28) obtained in this manner forms the output of the prefilter PFI(4). The clock period is equal to the period of the reference clock RIF(27) and the mean frequency is equal to the frequency of reference clock RIF(27) from which the mean frequency of pulses IMP(26) generated by the modulator SD MOD (19) is subtracted.

The free oscillation frequency of VCO_ON/OFF, keeping constant all remaining parameters, depends on the value of constant XO(24) added by means of the adder SOM(12) with a linear law, while its gain is inversely proportional to the gain K of block GUA(17).

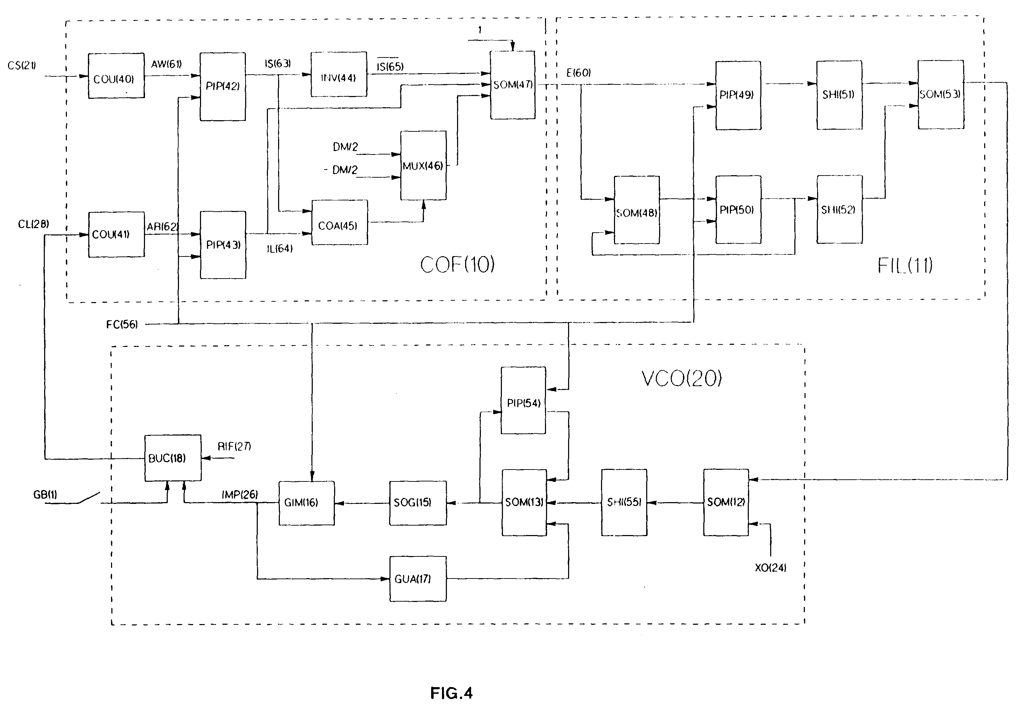

A preferred implementation of DPLL_ON/OFF is referred in Figure 4. In this figure it is shown a schematization of a modality of digital fulfilment of blocks COF (10), FIL(11) and VCO(20) forming a DPLL_ON/OFF (Figure 3).

The phase comparator COF(10) supplies the phase error, given in [UI] and sampled in conjuction with the instants programmed by the clock FC(56), between the clock CS(21) associated to the received information data flow and the clock CL(28) of DPLL output.

In particular the phase error E(60) is given by:

$$E(60) = | \, I_L - I_S \, |_{DM} - DM/2 \qquad (1)$$

where $I_L$ and $I_S$ show respectively the status of counters COU(41) and COU(40) in conjuction with the upgrading behaviours of clock FC(56), and DM indicates an integer constant of suitable value.

The above mentioned counters count in a cyclic manner between 0 and DM - 1 and the numerical representations of its status, $I_L$ and $I_S$, are always numbers included between 0 and DM -1.

In this condition it is easy to get that the equation (1) can be written in the following manner:

$$E(60) = I_L + \overline{I}_S - DM/2 + 1 \text{ if } I_L \geq I_S \qquad (2a)$$

$$E(60) = I_L + \overline{I}_S - DM/2 + 1 \text{ if } I_L < I_S \qquad (2b)$$

This processing is made by the blocks COA(45), INV(44), MUX(46) and SOM(47). In particular the amplitude comparator COA(45) compares the value of $I_L$ and $I_S$ and supplies an output that selects, by means of MU(46), the value DM/2 or -DM/2 that must be, each time, used by the adder SOM(47) with the aim of obtaining the usual value of the error E(60). The block INV(44) carries out the inversion of all of elements of the bus $I_S$ and feeds the bus shown by $\overline{I}_S$.

The loop filter FIL(11) has a pole in the origin and it is sized so that the band gain of DPLL is under 0.5 dB. It is formed by two adders SOM(48) and SOM(53), by two PIPOs (Parallel Input Parallel Output) PIP(49) and PIP(50) and by two shifters SHI(51) and SHI(52) that calculate the product between the input and the number expressed as a power of the base two showing the gain of the same shifter.

The VCO_ON/OFF VCO(20), as schematized in Figure 4, forms a preferred digital implementation of the same device. The integration operation, made by the block ITG(14) of Figure 3, is obtained by digital process by means of the accumulator formed by the PIPO PIP (54) and by the adder SOM(13) of Figure 14. All of other blocks of Figure 4 forming the VCO_ON/OFF VCO(20) have the same function of homonymous blocks of Figure 3 and differ from these ones only for being implemented in a digital manner. It can be easily shown that the VCO_ON/OFF VCO(20) of Figure 4 has a gain and a free oscillation frequency given respectively by:

$$ko = -fc * k1/k \qquad (3)$$

$$fo = fr - ko * xo \qquad (4)$$

where fc indicates the clock frequency FC(56), fr the reference clock frequency RIF(27), k1 the gain of shifter SHI(55), k the gain of the block GUA(17) and xo the value of the constant XO(24).

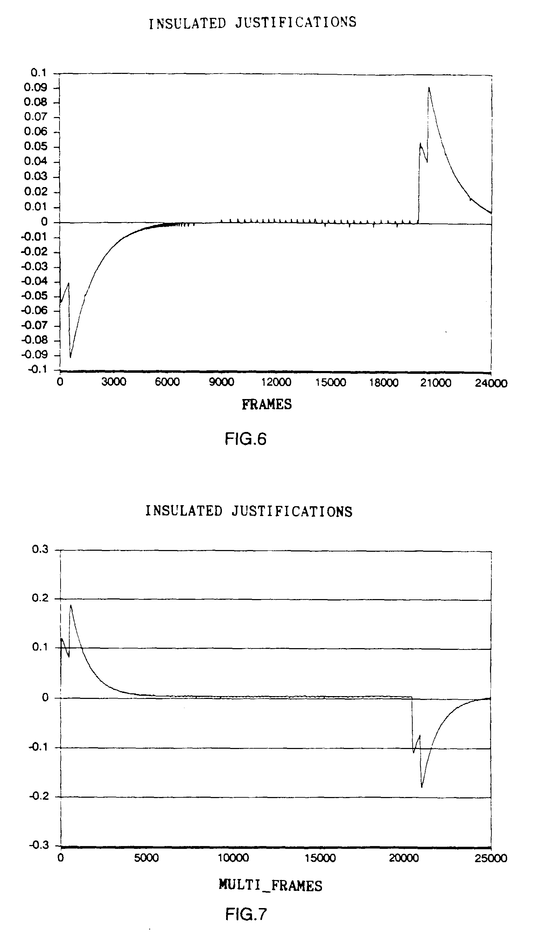

A preferred implementation of said method is referred in Figure 5. The information data received DRV (67) and clocked by the clock CS(21), holding all of types of precedently indicated redundancies GB(1), RF(2) and GP(3), are clocked by the clock CL(28) before being filtered by the "traditional" APLL APL(6). The above mentioned new re-clocking is possible owing to the presence of the elastic memory (buffer) BUF(66), in which the information bits received with the rate supplied respectively by clocks CS(21) and CL(28) are written and read. This is obtained using the writing address AW(61) and reading address AR(62) of the elastic memory BUF(66), respectively the status of counters COU (40) and COU(41). Therefore the re-clocked data DRT (68) and the related timing clock CL(28) are sent to a "traditional" APLL that erases the holes present on the clock CL(28) and reconstructs a continuous data flow.

The Figure 6 and Figure 7 refer some results obtained simulating the preferred implementation of said method. They represent the peak_peak jitter, expressed in [UI] and estimated at the output of the measure bandpass filter as defined by the international standard (table 7.1 of recommendation G.783), caused by the sequence of pointer justifications representing the more critical situation in terms of phase noise introduced by the SDH network. This sequence, formed by a double pointer justification followed by another double pointer justification of the opposite polarity, in case the periods between adjustments of opposite polarity are greater than the receiver time sonstant, is assumed as reference by the international standard. This standard establishes that the peak peak jitter associated to the above mentioned sequence must be under 0.75 [UI]. The Figure 6 and Figure 7 show how said method allows to satisfy this standard with wide margin.

The Figure 6 (Figure 7) referes to a tributary 34368 kbit/sec (2048 kbit/sec) mapped in a frame STM1 (Synchronous Transport Module) according to the multiplexing path that goes from VC-3 (VC-12) to VC-4. The measure band-pass filter of the standardization organization for this tributary has upper and lower corner frequencies at 100 Hz (20 Hz) and 800 kHz (100 kHz), respectively, and shows a slope of 20 dB for out of band decades.

## Claims

1. A method for reducing in reception the phase noise introduced by pointer justifications from a SDH network (Synchronous Digital Hierarchy Network) in the transmitted numerical signal, in which method there are combined a) occasional redundancies associated to bit justifications (GB(1)) and b) the fixed redundancies (RF(2)) with c) the prefiltered occasional redundancies associated to the pointer justifications (GP(3)), and the combined signal is filtered in an Analog Phase Locked Loop (APLL), **characterized** in that the occasional redundancies associated to the pointer justifications (GP(3)) and further at least a part of fixed redundancies (RF(2)) with or without bit justifications are prefiltered in two stages, and the prefiltered signals (b) and (c) are combined only with the eventual occasional redundancies associated to the bit justifications (GB(1)) in the case in which these last ones were not prefiltered.

2. A method according to claim 1, **characterized** in that it includes the steps of

   I) establishing the ideal response law of prefilter;
   II) detecting the presence of occasional redundancies and establishing if it is necessary to prefilter also the redundancies associated to the bit justifications (GB(1));
   III) deciding and performing the pulse suppression on the reference clock so that, with a phase difference as minimum as possible, the prefilter output coincides with the ideal output established at (I);
   IV) accommodating the bit justifications, in the case in which these are not prefiltered, in the holed clock obtained at point (III);
   V) filtering, by a Phase Locked Loop (PLL), the data flow received and re-clocked by the clock obtained in (IV) for reconstructing a continuous data flow.

3. A method according to claim 2, **characterized** in that in step (I) as the ideal response law of prefilter, the transfer function of a second order Phase Locked Loop (PLL) is established in which the output frequency variation is obtained by suppressing pulses in a reference clock without changing the oscillation period.

4. A method according to claim 3, in which a second order Digital Phase Locked Loop (DPLL) is obtained by a modulator SD (Sigma Delta) generating pulses in conjunction with pulses which are suppressed in a reference clock and using said DPLL for prefiltering.

5. A method according to claim 4, in which the output phase of said Digital Phase Locked Loop (DPLL) reproduces the phase obtained by an Analog Phase Locked Loop (APLL) with a phase difference as minimum as possible.

6. A device for reducing in reception the phase noise introduced by pointer justifications from a SDH network (Synchronous Digital Hierarchy Network) in the transmitted numerical signal, for the implementation of the method according to one of the preceding claims, comprising a prefilter (PFI(4)) and a phase detector (COM(5)) for prefiltering and combining
   a) the occasional redundancies associated to the bit justifications (GB(1)), b) the fixed redundancies (RF(2)) and c) the occasional redundancies associated to the pointer justifications (GP(3)), and an APLL (Analog Phase Locked Loop) for filtering the combined signal,
   **characterized** in that it includes a prefilter formed by a phase comparator (COF(10)), a numerical filter (FIL(11)) and a voltage controlled oscillator (VCO) of type ON/OFF.

7. A device according to claim 6, characterized in that the prefilter (PFI(4)) is associated to an elastic memory (BUF(66)) for reclocking the received data that, after the clocking operation, can be easily filtered.

## Patentansprüche

1. Verfahren um beim Empfang Phasenrauschen zu verringern, das durch Zeiger-Ausgleichseinstellungen von einem SDH-Netzwerk (synchrones, digitales Hierarchienetzwerk) im übertragenen numerischen Signal eingefügt wurde, wobei bei diesem Verfahren a) zufällige Redundanzen in Zusammenhang mit Bit-Ausgleichseinstellungen (GB(1)) und b) feste Redundanzen (RF(2)) mit c) den vorgefilterten, zufälligen Redundanzen in Zusammenhang mit den Zeiger-Ausgleichseinstellungen (GP(3)) kombiniert werden und das kombinierte Signal in einer analogen phasensynchronisierten Schaltung (APLL-Schaltung) gefiltert wird, **dadurch gekennzeichnet**, dass die zufälligen Redundanzen in Zusammenhang mit den Zeiger-Ausgleichseinstellungen (GP(3)) und ferner zumindest ein Teil der festen Redundanzen (RF(2)) mit oder ohne Zeiger-Ausgleichseinstellungen in zwei Stufen vorgefiltert werden und die vorgefilterten Signale (b) und (c) nur dann mit den eventuellen zufälligen Redundanzen in Zusammenhang mit den Bit-Ausgleichseinstellungen (GB(1)) kombiniert werden, wenn letztere nicht vorgefiltert wurden.

2. Verfahren nach Anspruch 1, **dadurch gekennzeichnet**, dass es die folgenden Schritte umfasst:

I) es wird die ideale Antwortregel des Vorfilters erstellt;

II) es wird das Vorhandensein zufälliger Redundanzen ermittelt, und es wird festgestellt, ob es erforderlich ist, auch die Redundanzen in Zusammenhang mit den Bit-Ausgleichseinstellungen (GB(1)) vorzufiltern;

III) es wird über Impulsunterdrückung im Bezugstaktsignal entschieden und diese so ausgeführt, dass das Ausgangssignal des Vorfilters, mit kleinstmöglicher Phasendifferenz, mit dem unter (I) erstellten idealen Ausgangssignal übereinstimmt;

IV) es werden die Bit-Ausgleichseinstellungen, wenn diese nicht vorgefiltert sind, im gemäß dem Punkt (III) erhaltenen Taktsignal mit Löchern untergebracht;

V) es wird der empfangene Datenfluss, der durch das im Punkt (IV) erhaltene Taktsignal neu getaktet wurde, durch eine phasensynchronisierte Schleife (PLL) gefiltert, um wieder einen kontinuierlichen Datenfluss herzustellen.

3. Verfahren nach Anspruch 2, **dadurch gekennzeichnet**, dass im Schritt (I) als ideale Antwortregel des Vorfilters die Übertragungsfunktion einer phasensynchronisierten Schaltung (PLL-Schaltung) zweiter Ordnung erstellt wird, bei der die Änderung der Ausgangsfrequenz dadurch erhalten wird, dass Impulse in einem Bezugstaktsignal ohne Änderung der Schwingungsperiode unterdrückt werden.

4. Verfahren nach Anspruch 3, bei dem eine digitale phasensynchronisierte Schaltung (DPLL-Schaltung) zweiter Ordnung durch einen SD(Sigma-Delta)-Modulator erhalten wird, der Impulse in Zusammenhang mit solchen Impulsen erzeugt, die in einem Bezugstaktsignal unterdrückt wurden, wobei die DPLL-Schaltung zur Vorfilterung verwendet wird.

5. Verfahren nach Anspruch 4, bei dem die Ausgangsphase der digitalen phasensynchronisierten Schaltung (DPLL-Schaltung) die durch eine analoge phasensynchronsierte Schaltung (APLL-Schaltung) erhaltene Phase mit der kleinstmöglichen Phasendifferenz reproduziert.

6. Vorrichtung zum Verringern, beim Empfang, des Phasenrauschens, das durch Zeiger-Ausgleichseinstellungen von einem SDH-Netzwerk (synchrones digitales Hierarchienetzwerk) im übertragenen numerischen Signal hervorgerufen wurde, um das Verfahren gemäß einem der vorstehenden Ansprüche zu realisieren, mit

- einem Vorfilter (PFI(4)) und
- einem Phasendetektor (COM(5)) zum Vorfiltern und Kombinieren

a) der zufälligen Redundanzen in Zusammenhang mit Bit-Ausgleichseinstellungen (GB(1)),
b) der festen Redundanzen (RF(2)) und
c) der zufälligen Redundanzen in Zusammenhang mit den Zeiger-Ausgleichseinstellungen (GP(3)), und

- einer APLL-Schaltung (analoge phasensynchronisierte Schaltung) zum Filtern des kombinierten Signals;

**dadurch gekennzeichnet**, dass sie ein Vorfilter aufweist, das aus einem Phasenkomparator (COF (10)), einem numerischen Filter (FIL(11)) und einem spannungsgesteuerten Oszillator (VCO) vom AN/AUS-Typ besteht.

7. Vorrichtung nach Anspruch 6, **dadurch gekennzeichnet**, dass das Vorfilter (PFI(4)) einem variablen Speicher (BUF(66)) zum Neutakten der empfangenen Daten zugeordnet ist, die, nach dem Taktvorgang, leicht gefiltert werden können.

**Revendications**

1. Procédé pour réduire à la réception, dans le signal numérique émis, le bruit de phase introduit par des justifications par pointeurs à partir d'un réseau SDH (réseau à hiérarchie numérique synchrone), dans lequel procédé sont combinées a) des redondances occasionnelles associées à des justifications (GB (1)) par bits et b) les redondances fixes (RF(2)), avec c) les redondances occasionnelles préfiltrées associées aux justifications (GP(3)) par pointeurs, et le signal combiné est filtré dans une boucle analogique à phase asservie (APLL), caractérisé en ce que les redondances occasionnelles associées aux justifications (GP(3)) par pointeurs, ainsi qu'au moins une partie des redondances fixes (RF(2)) avec ou sans justifications par bits sont préfiltrées dans deux étages, et les signaux préfiltrés (b) et (c) ne sont combinés qu'avec les redondances occasionnelles finales associées aux justifications (GB (1)) par bits dans le cas où ces dernières n'ont pas été préfiltrées.

2. Procédé selon la revendication 1, caractérisé en ce qu'il comprend les étapes consistant à

I) établir la loi de réponse idéale de préfiltrage;
II) détecter la présence de redondances occasionnelles et établir s'il est nécessaire de préfiltrer aussi les redondances associées aux justifications (GB(1)) par bits;
III) décider et effectuer la suppression d'impulsions dans l'horloge de référence de façon que, avec une différence de phase aussi minime que possible, la sortie du préfiltre coïncide avec la sortie idéale établie en (I);
IV) recevoir les justifications par bits, dans le cas où celles-ci ne sont pas préfiltrées, dans l'horloge à trous obtenue au point (III);
V) filtrer, par une boucle à phase asservie (PLL), le flux de données reçu et resynchronisé par l'horloge obtenue en (IV) pour reconstruire un flux de données continu.

3. Procédé selon la revendication 2, caractérisé en ce que, lors de l'étape (I) qui établit la loi de réponse idéale de préfiltrage, il est établi la fonction de transfert d'une boucle à phase asservie (PLL) de second ordre dans laquelle la variation de la fréquence de sortie est obtenue en supprimant des impulsions dans une horloge de référence sans modifier la période d'oscillation.

4. Procédé selon la revendication 3, dans lequel une boucle numérique à phase asservie (DPLL) est obtenue par un modulateur SD (Sigma Delta) qui génère des impulsions conjointement avec des impulsions qui sont supprimées dans une horloge de référence et qui utilise ladite DPLL pour le préfiltrage.

5. Procédé selon la revendication 4, dans lequel la phase de sortie de ladite boucle numérique à phase asservie (DPLL) reproduit la phase obtenue par une boucle analogique à phase asservie (APLL) avec une différence de phase aussi minime que possible.

6. Dispositif pour réduire à la réception, dans le signal numérique émis, le bruit de phase introduit par des justifications par pointeurs à partir d'un réseau SDH (réseau à hiérarchie numérique synchrone), servant à mettre en oeuvre le procédé selon l'une quelconque des revendications précédentes, comprenant un préfiltre (PFI(4)) et un détecteur (COM(5)) de phase pour préfiltrer et combiner a) les redondances occasionnelles associées aux justifications (GB(1)) par bits et b) les redondances fixes (RF(2)) et c) les redondances occasionnelles associées aux justifications (GP(3)) par pointeurs, et une boucle analogique à phase asservie (APLL) pour filtrer le signal combiné,
caractérisé en ce qu'il comprend un préfiltre formé par un comparateur (COF(10)) de phase, un filtre numérique (FIL(11)) et un oscillateur (VCO) commandé en tension du type tout ou rien.

7. Dispositif selon la revendication 6, caractérisé en ce que le préfiltre (PFI(4)) est associé à une mémoire élastique (BUF(66)) pour resynchroniser les données reçues qui, après l'opération de synchronisation, peuvent être facilement filtrées.

FIG.1

FIG.2

FIG.5

8

FIG.3

**FIG.4**

INSULATED JUSTIFICATIONS

FIG.6

INSULATED JUSTIFICATIONS

FIG.7